# EUROPÄISCHE PATENTSCHRIFT

(11) **EP 4 114 157 B1**
(45) Veröffentlichungstag und Bekanntmachung des Hinweises auf die Patenterteilung: **18.02.2026**
(21) Anmeldenummer: 21183053.4
(22) Anmeldetag: 01.07.2021
(51) Int. Cl.: H05K 7/14

(54) **ANORDNUNG FÜR EIN REDUNDANTES STEUERUNGSSYSTEM**
ASSEMBLY FOR REDUNDANT CONTROL SYSTEM
AGENCEMENT POUR UN SYSTÈME REDONDANT DE COMMANDE

(43) Veröffentlichungstag der Anmeldung: 04.01.2023
(73) Patentinhaber: Siemens Aktiengesellschaft, 80333 München (DE)
(72) Erfinder: Grosch, Thomas, 90574 Roßtal (DE); Renschler, Albert, 76275 Ettlingen (DE)
(74) Vertreter: Siemens Patent Attorneys

(56) Entgegenhaltungen:
- EP-B1- 2 544 058
- EP-B1- 2 982 018

## Beschreibung

Die Erfindung betrifft eine Anordnung für ein redundantes Steuerungssystem. Die Anordnung weist dazu einen ersten Baugruppenträger auf, welcher ausgestaltet ist, mit mehreren Steckplätzen zur Aufnahme einzelner Baugruppen, welche modular zusammengestellt ein erstes Automatisierungssystem bilden, und weiterhin weist die Anordnung einen zweiten Baugruppenträger mit weiteren mehreren Steckplätzen zur Aufnahme weiterer einzelner Baugruppen auf, welche ebenfalls modular zusammengestellt ein zweites Automatisierungssystem bilden.

Die Erfindung bezieht sich auf hochverfügbare Automatisierungsgeräte, wobei in der Regel zwei Automatisierungsgeräte parallel laufen und einen Prozess steuern. Sollte ein Automatisierungssystem ausfallen, so übernimmt in der Regel stoßfrei das andere Automatisierungssystem die Steuerung.

Aus der EP 0 497 147 A1 ist ein Verfahren und eine Vorrichtung zum Betreiben eines redundant aus zwei Teilsystemen aufgebauten Automatisierungssystems bekannt.

In der EP 2 982 018 B1 wird eine Stromversorgungseinheit zum Umwandeln einer Eingangsspannung in eine Ausgangsspannung, insbesondere ein Schaltnetzteil offenbart, wobei weiterhin ein Verfahren zum ausgangsseitigen Parallelschalten mehrerer Stromversorgungseinheiten erläutert wird.

Die EP 2 544 058 B1 zeigt eine Rückwandbusplatine für eine hochverfügbare Steuerung.

Für eine Strom- bzw. Spannungsversorgung benötigen diese beiden Teilsysteme eine Stromversorgungsbaugruppe. Um auch die Verfügbarkeit der Stromversorgung zu erhöhen, können oder werden in der Regel in jedem Teilsystem auch zwei redundant arbeitende Stromversorgungsbaugruppen eingesetzt.

Mit zwei Stromversorgungsbaugruppen kann eine redundante Stromversorgung eines Baugruppenträgers aufgebaut werden. Um auch für den zweiten Baugruppenträger eine redundante Stromversorgung aufzubauen, muss dieser ebenfalls mit zwei redundanten Stromversorgungsbaugruppen bestückt werden. Dies Art der Stromversorgungsredundanz empfiehlt sich immer dann, wenn die Verfügbarkeit der Steuerung noch weiter verbessert werden soll, insbesondere dann, wenn die Steuerungen an einem unzuverlässigen Netz zu betreiben sind.

Nach dem bekannten Stand der Technik werden bei redundanten Automatisierungssystemen in der Regel zwei Baugruppenträger verbaut, die entweder in einem Schaltschrank oder in getrennten Schaltschränken voneinander installiert werden. Insbesondere im redundanten Automatisierungssystem kommt der Redundanz der Stromversorgung der Baugruppenträger eine zusätzliche Bedeutung zu. Ein Fehler in der Stromversorgungsbaugruppe soll nicht zum Ausfall des Baugruppenträgers führen. Redundante Stromversorgungen werden dabei meist durch Stecken von zusätzlichen, redundanten Stromversorgungsbaugruppen im Baugruppenträger realisiert. Bei einem redundanten Automatisierungssystem, welches in einem Schaltschrank montiert ist, werden dabei z.B. vier Stromversorgungsbaugruppen in unmittelbarer räumlicher Nähe zueinander gesteckt. Die dafür benötigten Steckplätze können dann nicht mehr für andere Baugruppen im Baugruppenträger verwendet werden.

Von Nachteil ist es bei den bekannten Automatisierungssystemen bzw. deren doppelt ausgelegten Baugruppenträgern, dass sich der zur Verfügung stehende Platz, beispielsweise im Schaltschrank für zusätzliche Baugruppen reduziert, weil eben mindestens für jedes Automatisierungssystem bzw. für jeden der Baugruppenträger zwei Steckplätze für eine redundante Stromversorgung geopfert werden müssen.

Es ist die Aufgabe der vorliegenden Erfindung, eine Anordnung von Baugruppenträgern zur Verfügung zu stellen, welche eine redundante Stromversorgung ermöglicht und dennoch weniger Steckplätze für die redundanten Stromversorgungsbaugruppen benötigt.

Die Aufgabe wird für die eingangs genannte Anordnung dadurch gelöst, dass ein Steckplatz des ersten Baugruppenträgers als eine erste Versorgungsmodul-Aufnahme mit ersten Kontaktmitteln ausgestaltet ist, und ein Steckplatz des zweiten Baugruppenträgers als eine zweite Versorgungsmodul-Aufnahme mit zweiten Kontaktmitteln ausgestaltet ist, wobei die erste und die zweite Versorgungsmodul-Aufnahme derart aufgebaut sind, dass sie sich zwischen dem ersten Baugruppenträger und dem zweiten Baugruppenträger konstruktiv und elektrisch zu einem Versorgungs-Grundmodul ergänzen, wobei die ersten Kontaktmittel ausgestaltet sind, den ersten und den zweiten Baugruppenträger mit einer Versorgungsspannung zu versorgen und die zweiten Kontaktmittel ausgestaltet sind, den zweiten und den ersten Baugruppenträger mit einer Versorgungsspannung zu versorgen, und das aus dem Versorgungsmodul-Aufnahmen gebildete Versorgungs-Grundmodul ausgestaltet ist, ein erstes Versorgungsspannungs-Modul, ein zweites Versorgungsspannungs-Modul und ein drittes Versorgungsspannungs-Modul aufzunehmen, wobei die Versorgungsmodul-Aufnahmen mechanisch miteinander verrastet sind und alle drei Versorgungsspannungs-Module in der Lage sind, beide Baugruppenträger sicher mit einer Versorgungsspannung zu versorgen.

Erfindungsgemäß wird die eingangs genannte Aufgabe nun durch eine Modularisierung der zuvor monolitisch genutzten Stromversorgungs-Baugruppen gelöst, wobei nun durch die Modularisierung der Stromversorgungs-Baugruppen ein effizienterer Aufbau der Baugruppenträger und damit eine bessere Raumausnutzung in einem Schaltschrank ermöglicht wird. Die Stromversorgungsbaugruppe wurde nun erfindungsgemäß modularisiert, wobei zum einen eine Versorgungsmodul-Aufnahme, ein Kontaktmittel, und ein Versorgungs-Grundmodul mit entsprechenden Aufnahmeplätzen für die Versorgungsspannung-Module als eine Art Baukastensystem zur Verfügung steht.

Will man nun bei zwei Baugruppenträgern ebenfalls für eine redundante Stromversorgung sorgen, so ist ein Bestandteil der Baugruppenträger so ausgestaltet, dass beide Baugruppenträger bezüglich einer Versorgungsspannung kontaktiert werden können. Dementsprechend ist ein Steckplatz ausgestaltet als eine erste Versorgungsmodul-Aufnahme. In diese Versorgungsmodul-Aufnahme kann ein Versorgungsspannungs-Modul zur Versorgung der Baugruppenträger gesteckt werden. Die Kontaktmittel sind dabei derart ausgestaltet, dass sowohl ein linksseitiger Baugruppenträger als auch ein rechtsseitiger Baugruppenträger mit einer Versorgungsspannung versorgt werden können.

Sind die Baugruppenträger derart angeordnet, dass sie direkt nebeneinanderstehen und wurde aus dem einzelnen Versorgungsmodul-Aufnahmen ein Versorgungs-Grundmodul gebildet, so können drei Versorgungsspannungs-Module gesteckt werden. Alle drei Versorgungsspannungs-Module sind dabei in der Lage, beide Baugruppenträger sicher mit einer Versorgungsspannung zu versorgen. Als besonderer Vorteil wird angesehen, dass die Versorgungsspannungs-Module einzeln im laufenden Betrieb ausgetauscht werden können. Es ergibt sich eine sogenannte Zweiaus-Drei-Redundanz (2oo3) für die Stromversorgung der beiden Baugruppenträger. Jedes der drei Versorgungsspannungs-Module könnte nun ausfallen, ohne dass die Stromversorgung beider Baugruppenträger gefährdet wäre.

Im Hinblick auf eine hochverfügbare Steuerung eines industriellen Prozesses ist es von Vorteil, wenn das erste Automatisierungssystem und das zweite Automatisierungssystem jeweils als ein System zur Erhöhung der Ausfallsicherheit durch eine Wechselfunktion zwischen den beiden Automatisierungssystemen bei einem einseitigen Ausfall eines Automatisierungssystems ausgelegt sind.

Sollte dennoch mal ein gänzlicher Ausfall des Systems hervorgerufen werden und müssen beide Automatisierungssystem wieder neu anlaufen, so ist es von Vorteil, wenn die Anordnung mit einen Überwachungsmittel versehen ist, welches ausgestaltet ist, jeweils einen aktuellen Systemzustand der beiden Automatisierungssysteme aufzuzeichnen, wobei das Überwachungsmittel weiterhin ausgestaltet ist, nach einem Ausfall beider Automatisierungssysteme einen priorisierten Hochlauf desjenigen Automatisierungssystems zu unterstützen, für welches ein zeitlich aktuellerer Systemzustand vorliegt.

In vielen Anwendungsfällen soll das redundante Automatisierungssystem nach dem Einschalten der Stromversorgung mit dem zuletzt aktuellen Systemzustand wieder anlaufen. Der zuletzt aktuelle Systemzustand unterscheidet sich u.U. zwischen den Automatisierungsgeräten der beiden Baugruppenträger, wenn z.B. deren Stromversorgungen zu unterschiedlichen Zeitpunkten ausgefallen sind.

Weiterhin ist es vorteilhaft, wenn das Versorgungs-Grundmodul teilbar aufgebaut ist, welches es ermöglicht, während des Betriebes einen Baugruppenträger zu tauschen ohne dass das jeweilige andere Automatisierungssystem ausfällt.

Anhand der Zeichnung wird die Erfindung in einem Ausführungsbeispiel näher erläutert. Es zeigt
- FIG 1: eine Anordnung mit einem Baugruppenträger nach dem Stand der Technik,
- FIG 2: die verbesserte Anordnung mit den verbesserten Baugruppenträgern,
- FIG 3: eine Teilansicht des Baugruppenträgers auf die Versorgungsmodul-Aufnahmen,
- FIG 4: eine Verschaltung der Kontaktmittel,
- FIG 5: ebenfalls die Verschaltung der Kontaktmittel mit einer Darstellung der Aufnahmeplätze und
- FIG 6: das Versorgungs-Grundmodul mit einem zusätzlichen Überwachungsmittel.

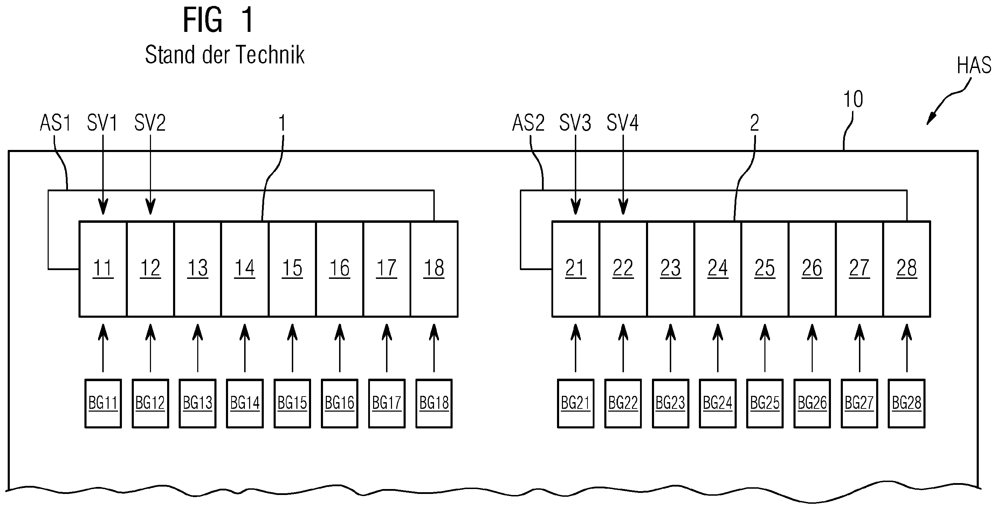

Gemäß der FIG 1 ist eine Anordnung HAS mit einem ersten Baugruppenträger 1 und einem zweiten Baugruppenträger 2 dargestellt. Der erste Baugruppenträger 1 weist mehrere Steckplätze 11,...,18 zur Aufnahme einzelner Baugruppen BG11,...,BG18 auf. Die Baugruppen BG11,...,18 für den ersten Baugruppenträger 1 können zu einem ersten Automatisierungssystem AS1 modular zusammengestellt werden. In einem zweiten Baugruppenträger 2 mit weiteren Steckplätzen 21,...,28 zur Aufnahme weiterer einzelner Baugruppen BG21,...,28, kann mit diesen ein zweites Automatisierungssystem AS2 ebenfalls modular zusammengestellt werden. Das erste Automatisierungssystem AS1 und das zweite Automatisierungssystem AS2 sind als hochverfügbare Automatisierungssysteme redundant ausgestaltet.

Auf dem ersten Steckplatz 11 des ersten Baugruppenträgers 1 ist eine erste Versorgungseinheit SV1 gesteckt, damit für den ersten Baugruppenträger 1 eine Versorgung redundant ausgeführt ist, wird auf dem zweiten Steckplatz 12 des ersten Baugruppenträgers 1 eine weitere zweite Versorgungseinheit SV2 gesteckt.

Da auch das zweite Automatisierungssystem AS2 in dem zweiten Baugruppenträger 2 eine redundante Stromversorgung erhalten soll, ist auf dem ersten Steckplatz 21 des zweiten Baugruppenträgers 2 eine dritte Versorgungseinheit SV3 gesteckt, da auch das zweite Automatisierungssystem AS2 in Bezug auf eine Stromversorgung redundant ausgeführt sein soll, ist auf dem zweiten Steckplatz 22 des zweiten Baugruppenträgers 2 eine vierte Versorgungseinheit SV4 gesteckt.

Bei redundanten Automatisierungssystemen, die in einem Schaltschrank 10 montiert sind, werden nun vier Steckplätze benötigt, um die beiden Automatisierungssystem AS1,AS2 mit einer redundanten Stromversorgung zu realisieren.

Im ersten Baugruppenträger 1 werden zwei Steckplätze, nämlich der erste Steckplatz 11 und der zweite Steckplatz 12 für je eine Versorgungseinheit SV1,SV2 benötigt. Im zweiten Baugruppenträger 2 werden auf dem ersten Steckplatz 21 und dem zweiten Steckplatz 22 je eine Versorgungseinheit SV3,SV4 benötigt. Das bedeutet, es werden vier Steckplätze benötigt, die nun nicht mehr für andere Baugruppen im Baugruppenträger verwendet werden können.

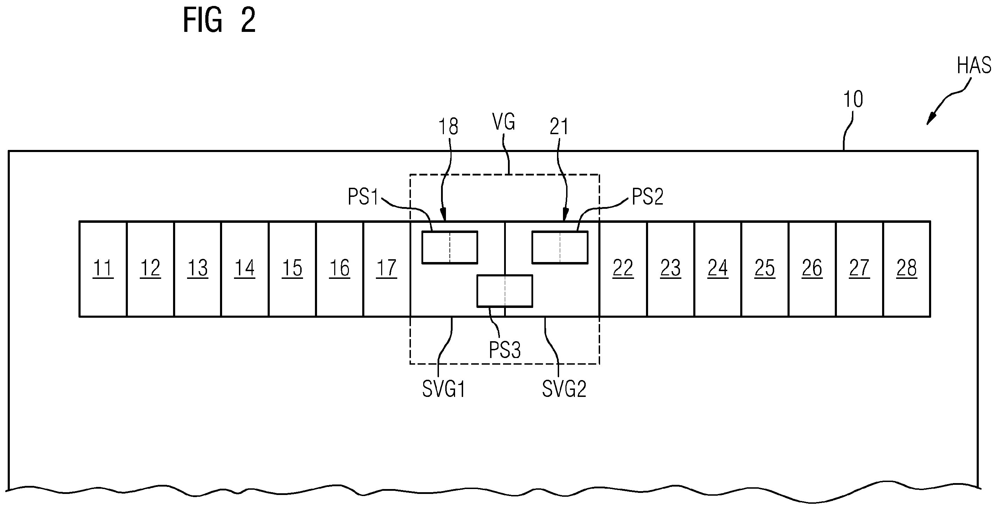

Gemäß der FIG 2 wird für die Anordnung HAS (High Availability System) mit dem ersten Baugruppenträger 1 und dem zweiten Baugruppenträger 2 eine Lösung vorgestellt, um Steckplätze einzusparen. Dazu wird ein Steckplatz 18 des ersten Baugruppenträgers 1 als eine erste Versorgungsmodul-Aufnahme SVG1 mit ersten Kontaktmitteln K1 ausgestaltet. Weiterhin wird in dem zweiten Baugruppenträger 2 ein erster Steckplatz 21 als eine zweite Versorgungsmodul-Aufnahme SVG2 mit zweiten Kontaktmitteln K2 ausgestaltet. Die erste und die zweite Versorgungsmodul-Aufnahme SVG1,SVG2 sind derart aufgebaut, dass sie sich zwischen dem ersten Baugruppenträger 1 und dem zweiten Baugruppenträger 2 konstruktiv und elektrisch zu einem Versorgungs-Grundmodul VG ergänzen. Die ersten Kontaktmittel K1 sind ausgestaltet, den ersten und den zweiten Baugruppenträger 1,2 mit einer Versorgungsspannung zu versorgen. Die zweiten Kontaktmittel K2 sind ausgestaltet, den zweiten und den ersten Baugruppenträger 2,1 mit einer Versorgungsspannung zu versorgen. Das aus den Versorgungsmodul-Aufnahmen SVG1,SVG2 gebildete Versorgungs-Grundmodul VG ist weiterhin ausgestaltet, ein erstes Versorgungspannungs-Modul PS1, ein zweites Versorgungsspannungs-Modul PS2 und ein drittes Versorgungsspannungs-Modul PS3 aufzunehmen.

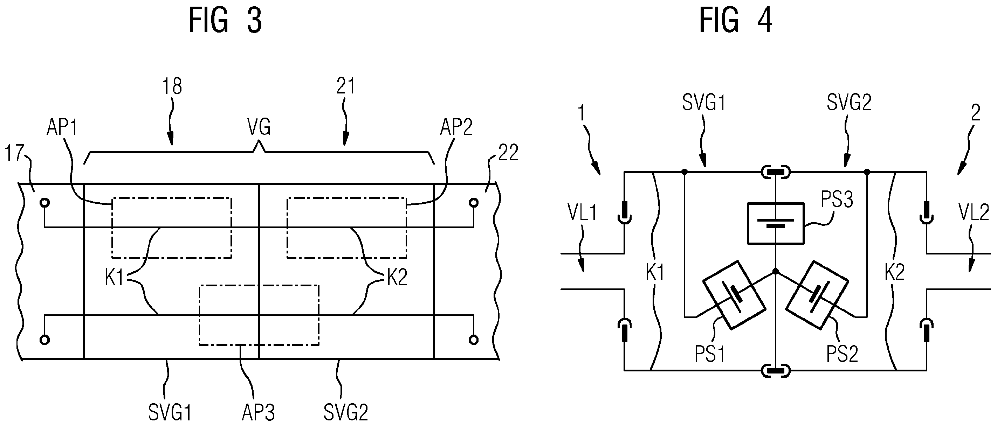

Die FIG 3 zeigt das Versorgungs-Grundmodul VG in einer detaillierteren Darstellung. Die erste Versorgungsmodul-Aufnahme SVG1 ist mit der zweiten Versorgungsmodul-Aufnahme SVG2 mechanisch verrastet. Die erste Versorgungsmodul-Aufnahme SVG1 weist erste Kontaktmittel K1 auf, welche linksseitig an dem ersten Baugruppenträger im siebten Steckplatz 17 adaptiert sind und rechtsseitig über die zweite Versorgungsmodul-Aufnahme SVG2 mit zweiten Kontaktmitteln K2 kontaktiert sind und damit rechtsseitig an den zweiten Steckplatz 22 des zweiten Baugruppenträgers 2 eine Spannungs- bzw. Stromversorgung sicherstellen. In die erste Versorgungsmodul-aufnahme SVG1 ist ein erster Aufnahmeplatz AP1 eingearbeitet. In die zweite Versorgungsmodul-Aufnahme SVG2 ist ein zweiter Aufnahmeplatz AP2 eingearbeitet. Ein dritter Aufnahmeplatz AP3 ist zum Teil in der ersten Versorgungsmodul-Aufnahme SVG1 und zum Teil in der zweiten Versorgungsmodul-Aufnahme SVG2 eingearbeitet.

Mit der FIG 4 ist eine mögliche Verschaltung des ersten Versorgungsspannungs-Moduls PS1, des zweiten Versorgungsspannungs-Modul PS2 und des dritten Versorgungsspannungs-Modul PS3 dargestellt. Die Versorgungsspannungs-Module PS1,PS2,PS3 stecken dazu in ihren jeweiligen Aufnahmeplätzen AP1,AP2,AP3.

Linksseitig sorgt eine Kontaktierung im ersten Baugruppenträger 1 für die Verbindung zu einer ersten Versorgungsleitung VL1. Rechtsseitig sorgt ebenfalls eine Kontaktierung zu einer Verbindung im zweiten Baugruppenträger 2 für eine zweite Versorgungsleitung VL2. Die Versorgungsspannungs-Module PS1,PS2,PS3 sind beispielsweise mit ihrem Minuspol in einem Sternpunkt zusammengefasst. Der Sternpunkt wird dann zu einer unteren Kontaktleitung der beiden Kontaktmittel K1,K2 geführt. Die jeweiligen Pluspunkte der Versorgungsspannungs-Module PS1,PS2,PS3 werden dann zu einer oberen Kontaktleitung der Kontaktmittel K1,K2 geführt. Damit die erste Versorgungsmodul-Aufnahme SVG1 und die zweite Versorgungsmodul-Aufnahme SVG2 getrennt werden können, sind die Trennstellen mit Stecckontakten ausgeführt.

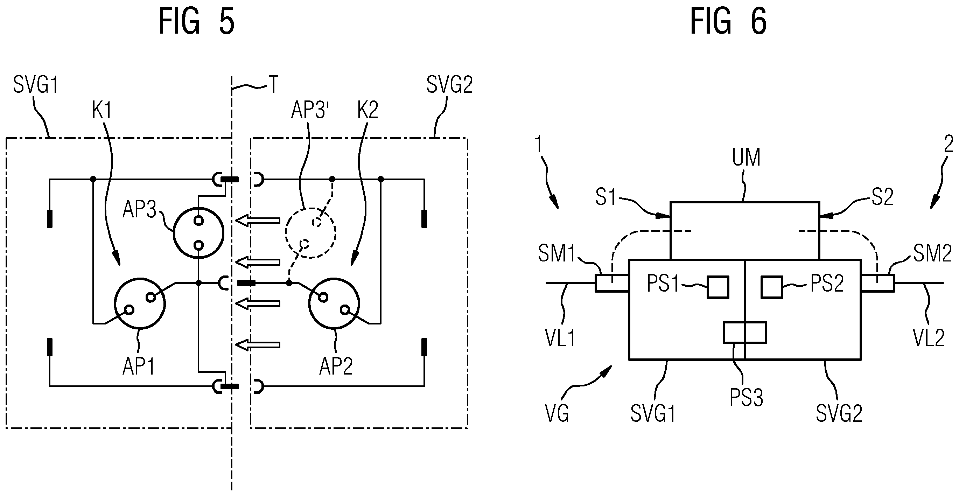

Die FIG 5 stellt noch einmal die Trennung der ersten Versorgungsmodul-Aufnahme SVG1 und der zweiten Versorgungsmodul-Aufnahme SVG2 dar. An einer Trennstelle T kann über Steckkontakte die erste Versorgungsmodul-Aufnahme SVG1 an die zweite Versorgungsmodul-Aufnahme SVG2 gesteckt werden. Die Kreise mit ihren Kontaktstellen stellen die Aufnahmeplätze AP1,AP2,AP3 für die Versorgungsspannungs-Module PS1,PS2,PS3 dar.

Die teilbare Ausgestaltung des Versorgungs-Grundmoduls VG ermöglicht es, während des Betriebes, einen defekten Baugruppenträger 1,2 zu tauschen, ohne dass das jeweilige andere Automatisierungssystem AS1,AS2 ausfällt. Es ist immer sichergestellt, dass zumindest ein Versorgungsspannungs-Modul PS1,PS2,PS3 das jeweilige nicht zu tauschende Automatisierungssystem mit Spannung versorgt.

Als weitere Verbesserung könnte in der zweiten Versorgungsmodul-Aufnahme SVG2 ein weiterer Aufnahmeplatz AP3' integriert sein.

Dieser Aufnahmeplatz AP3' ist normalerweise nicht bestückt, da ja nur drei Versorgungsspannungs-Module PS1,PS2,PS3 notwendig sind. Beim Trennen der beiden Baugruppenträger 1,2 kann durch den weiteren Aufnahmeplatz AP3'ein Versorgungsspannungs-Modul PS1,PS2,PS3 vor dem Zerlegen versetzt werden, in FIG 5 von links nach rechts. Dadurch kann immer sichergestellt werden, dass der verbleibende Baugruppenträger redundant, also mit zwei Versorgungsspannungs-Modulen, versorgt ist.

Die FIG 6 zeigt eine Weiterführung, wobei mit einem Überwachungsmittel UM, welches ausgestaltet ist, jeweils einen aktuellen Systemzustand der beiden Automatisierungssystem AS1,AS2 aufzuzeichnen, die Systemzustände der beiden Automatisierungsgeräte zu überwachen. Das Überwachungsmittel UM ist weiterhin dazu ausgestaltet, nach einem Ausfall beider Automatisierungssysteme AS1,AS2 einen priorisierten Hochlauf desjenigen Automatisierungssystems AS1 zu unterstützen, für welches ein zeitlich aktuellerer Systemzustand S1,S2 vorliegt. Dazu steuert das Überwachungsmittel UM entweder ein erstes Schaltmittel SM1 oder ein zweites Schaltmittel SM2 an. Die Schaltmittel SM1,SM2 sind jeweils in die Versorgungsleitungen VL1,VL2 geschaltet und je nachdem, welches Schaltmittel SM1,SM2 aktiv ist, wird entweder das Automatisierungssystem in dem ersten Baugruppenträger 1 oder das Automatisierungssystem AS2 in dem zweiten Baugruppenträger 2 gestartet.

## Patentansprüche

1. Anordnung (HAS) mit einem ersten Baugruppenträger (1) ausgestaltet mit mehreren Steckplätzen (11,...,18) zur Aufnahme einzelner Baugruppen (BG11,...,BG18), welche modular zusammengestellt ein erstes Automatisierungssystem (AS1) bilden und einem zweiten Baugruppenträger (2) mit weiteren mehreren Steckplätzen (21,...,28) zur Aufnahme weiterer einzelner Baugruppen (BG21,...,BG28), welche modular zusammengestellt ein zweites Automatisierungssystem (AS2) bilden,
wobei
- ein Steckplatz (18) des ersten Baugruppenträgers (1) als eine erste Versorgungsmodul-Aufnahme (SVG1) mit ersten Kontaktmitteln (K1) ausgestaltet ist und
- ein Steckplatz (21) des zweiten Baugruppenträgers (2) als eine zweite Versorgungsmodul-Aufnahme (SVG2) mit zweiten Kontaktmitteln (K2) ausgestaltet ist, wobei
- die erste und die zweite Versorgungsmodul-Aufnahme (SVG1, SVG2) derart aufgebaut sind, dass sie sich zwischen dem ersten Baugruppenträger (1) und dem zweiten Baugruppenträger (2) konstruktiv und elektrisch zu einem Versorgungs-Grundmodul (VG) ergänzen, wobei
- die ersten Kontaktmittel (K1) ausgestaltet sind den ersten und den zweiten Baugruppenträger (1,2) mit einer Versorgungsspannung zu versorgen und
- die zweiten Kontaktmittel (K2) ausgestaltet sind den zweiten und den ersten Baugruppenträger (1,2) mit einer Versorgungsspannung zu versorgen, und
- wobei das aus den Versorgungsmodul-Aufnahmen (SVG1, SVG2) gebildete Versorgungs-Grundmodul (VG) ausgestaltet ist ein erstes Versorgungsspannungs-Modul (PS1), ein zweites Versorgungsspannungs-Modul (PS2) und ein drittes Versorgungsspannungs-Modul (PS3) aufzunehmen, wobei die Versorgungsmodul-Aufnahmen (SVG1, SVG2) mechanisch miteinander verrastet sind und alle drei Versorgungsspannungs-Module (PS1,PS2,PS3) in der Lage sind, beide Baugruppenträger sicher mit einer Versorgungsspannung zu versorgen.

2. Anordnung (HAS) nach Anspruch 1, wobei das erste Automatisierungssystem (AS1) und das zweite Automatisierungssystem (AS2) jeweils als ein System zur Erhöhung der Ausfallsicherheit durch eine Wechselfunktion zwischen den beiden Automatisierungssystemen (AS1,AS2) bei einem einseitigen Ausfall eines Automatisierungssystems (AS2) ausgelegt sind.

3. Anordnung (HAS) nach Anspruch 1 oder 2 mit einem Überwachungsmittel (UM), welches ausgestaltet ist jeweils einen aktuellen Systemzustand (S1,S2) der beiden Automatisierungssysteme (AS1,AS2) aufzuzeichnen, wobei das Überwachungsmittel (UM) weiterhin ausgestaltet ist nach einem Ausfall beider Automatisierungssysteme (AS1,AS2) einen priorisierten Hochlauf desjenigen Automatisierungssystems (AS1) zu unterstützen, für welches ein zeitlich aktuellerer Systemzustand (S1,S2) vorliegt.

4. Anordnung (HAS) nach einem der Ansprüche 1 bis 3, wobei das Versorgungs-Grundmodul (VG) teilbar aufgebaut ist, welches es ermöglicht, während des Betriebes einen defekten Baugruppenträger (1,2) zu tauschen ohne dass das jeweilige andere Automatisierungssystem (AS2) ausfällt.

## Claims

1. Arrangement (HAS) with a first rack (1) embodied with a plurality of slots (11,...,18) for receiving individual assemblies (BG11,...,BG18), which form a first automation system (AS1) when assembled in a modular manner, and a second rack (2) with further pluralities of slots (21,...,28) for receiving further individual assemblies (BG21,...,BG28), which form a second automation system (AS2) when assembled in a modular manner,
wherein
- a slot (18) of the first rack (1) is embodied as a first supply module receptacle (SVG1) with first contact means (K1) and
- a slot (21) of the second rack (2) is embodied as a second supply module receptacle (SVG2) with second contact means (K2), wherein
- the first and the second supply module receptacle (SVG1,SVG2) are constructed in such a manner that they complement one another from a structural and electrical perspective between the first rack (1) and the second rack (2) to form a supply base module (VG), wherein
- the first contact means (K1) are embodied to supply the first and the second rack (1,2) with a supply voltage and
- the second contact means (K2) are embodied to supply the second and the first rack (1,2) with a supply voltage, and
- wherein the supply base module (VG) formed by the supply module receptacles (SVG1,SVG2) is embodied to receive a first supply voltage module (PS1), a second supply voltage module (PS2) and a third supply voltage module (PS3), wherein the supply module receptacles (SVG1, SVG2) are mechanically latched to one another and all three supply voltage modules (PS1,PS2,PS3) are capable of supplying both racks with a supply voltage in a secure manner.

2. Arrangement (HAS) according to claim 1, wherein the first automation system (AS1) and the second automation system (AS2) are each designed as a system for increasing the fail-safe operation by way of a changeover function between the two automation systems (AS1,AS2) in the event of a failure on one side of an automation system (AS2).

3. Arrangement (HAS) according to claim 1 or 2 with a monitoring means (UM), which is embodied to record a current system state (S1,S2) of the two automation systems (AS1,AS2) in each case, wherein the monitoring means (UM) is furthermore embodied, following a failure of the two automation systems (AS1,AS2), to support a prioritised startup of the automation system (AS1) for which a temporally more recent system state (S1,S2) is available.

4. Arrangement (HAS) according to one of claims 1 to 3, wherein the supply base module (VG) is constructed in a divisible manner, which makes it possible to swap a defective rack (1,2) during operation without the respective other automation system (AS2) failing.

## Revendications

1. Agencement (HAS) comprenant un premier support (1) de module ayant plusieurs emplacements (11, ..., 18) d'enfichage pour la réception de divers modules (BG11, ..., BG18), qui, rassemblés modulairement, forment un premier système (AS1) d'automatisation et un deuxième support (2) de module ayant d'autres plusieurs emplacements (21, ..., 28) d'enfichage pour la réception d'autres divers modules (BG21, ..., BG28), qui, rassemblés modulairement, forment un deuxième système (AS2) d'automatisation,
dans lequel
- un emplacement (18) d'enfichage du premier support (1) de module est conformé sous la forme d'un premier logement de module d'alimentation (SVG1) ayant des premiers moyens (K1) de contact et
- un emplacement (21) d'enfichage du deuxième support (2) de module est conformé sous la forme d'un deuxième logement de module d'alimentation (SVG2) ayant des deuxièmes moyens (K2) de contact, dans lequel
- le premier et le deuxième logements (SVG1, SVG2) de module d'alimentation sont construits de manière à se compléter entre le premier support (1) de module et le deuxième support (2) de module constructivement et électriquement en un module (VG) de base d'alimentation, dans lequel
- les premiers moyens (K1) de contact sont conformés pour alimenter le premier et le deuxième supports (1, 2) de module en une tension d'alimentation et
- les deuxièmes moyens (K2) de contact sont conformés pour alimenter le deuxième et le premier supports (1, 2) de module en une tension d'alimentation, et
- dans lequel le module de base d'alimentation (VG), formé des logements (SVG1, SVG2) de module d'alimentation, est conformé pour recevoir un premier module (PS1) de tension d'alimentation, un deuxième module (PS2) de tension d'alimentation et un troisième module (PS3) de tension d'alimentation, dans lequel les logements (SVG1, SVG2) de module d'alimentation sont encliquetés entre eux mécaniquement et tous les trois modules (PS1, PS2, PS3) de tension d'alimentation sont en mesure d'alimenter les deux supports de module de manière sécurisée en une tension d'alimentation.

2. Agencement (HAS) suivant la revendication 1, dans lequel le premier système (AS1) d'automatisation et le deuxième système (AS2) d'automatisation sont conçus chacun sous la forme d'un système d'augmentation de la sécurité à la défaillance par une fonction d'échange entre les deux systèmes (AS1, AS2) d'automatisation, lors d'une défaillance d'un seul côté d'un système (AS2) d'automatisation.

3. Agencement (HAS) suivant la revendication 1 ou 2, comprenant un moyen (UM) de contrôle, qui est conformé pour enregistrer respectivement un état (S1, S2) en cours des deux systèmes (AS1, AS2) d'automatisation, dans lequel le moyen (UM) de contrôle est conformé en outre pour, après une défaillance des deux systèmes (AS1, AS2) d'automatisation, soutenir un démarrage ayant priorité du système (AS1) d'automatisation pour lequel il y a un état (S1, S2) du système le plus récent dans le temps.

4. Agencement (HAS) suivant l'une des revendications 1 à 3, dans lequel le module (VG) de base d'alimentation est constitué de manière divisible, ce qui permet, pendant le fonctionnement d'un support (1, 2) de module défectueux, un remplacement sans que l'autre système (AS2) d'automatisation respective tombe en panne.
